**Europäisches Patentamt**

**European Patent Office**

**Office européen des brevets**

(19)

(11) **EP 1 104 096 A2**

(12) **EUROPÄISCHE PATENTANMELDUNG**

(43) Veröffentlichungstag:
 **30.05.2001 Patentblatt 2001/22**

(51) Int Cl.⁷: **H03G 7/00**

(21) Anmeldenummer: **00124611.5**

(22) Anmeldetag: **10.11.2000**

(84) Benannte Vertragsstaaten:
 **AT BE CH CY DE DK ES FI FR GB GR IE IT LI LU
 MC NL PT SE TR**
 Benannte Erstreckungsstaaten:
 **AL LT LV MK RO SI**

(30) Priorität: **27.11.1999 DE 19957220**

(71) Anmelder: **ALCATEL**
 **75008 Paris (FR)**

(72) Erfinder:
 • **Matt, Hans-Jürgen**
  **71686 Remseck (DE)**
 • **Walker, Michael**
  **73666 Baltmannsweiler (DE)**
 • **Maurer, Michael**
  **71336 Waiblingen (DE)**

(74) Vertreter: **KOHLER SCHMID + PARTNER**
 **Patentanwälte**
 **Ruppmannstrasse 27**
 **70565 Stuttgart (DE)**

(54) **An den aktuellen Geräuschpegel adaptierte Geräuschunterdrückung**

(57) Ein Verfahren zur Reduktion von Geräuschsignalen bei TK-Systemen für die Übertragung von akustischen Nutzsignalen, insbesondere menschlicher Sprache, bei dem der Leistungswert des Geräuschpegels N im aktuell benutzten TK-Kanal fortlaufend gemessen und/oder geschätzt wird, ist dadurch gekennzeichnet, dass in Abhängigkeit vom aktuellen Geräuschpegel N laufend der Grad der aktuell vorzunehmenden Reduktion des Geräuschpegels N nach einer vorgegebenen Funktion f(N) automatisch eingestellt wird. Damit kann unaufwendig ein Grad der Geräuschabsenkung angepasst an die jeweilige Situation ermittelt und zur Steuerung einer Geräuschunterdrükkung verwendet werden. Dabei ermöglicht das Verfahren mit einfachen Mitteln, einen für das menschliche Ohr möglichst angenehmen akustischen Gesamteindruck zu erzeugen, der je nach Geschmack an individuelle Bedürfnisse angepasst werden kann. Ein weiterer Vorteil des erfindungsgemäßen Verfahrens besteht darin, dass bei einem Bündel von Telefonkanälen, beispielsweise zwischen internationalen Vermittlungsstellen, die Geräuschsituation in jedem einzelnen Kanal, die ja von Kanal zu Kanal sehr verschieden sein kann, automatisch eingestellt und individuell optimiert werden kann. Vorzugsweise ist f(N) eine Funktion g(S/N), die vom Quotienten S/N aus dem Leistungswert des Signalpegels S der zu übertragenden Nutzsignale und dem Leistungswert des Geräuschpegels N abhängt.

Fig. 2 a

EP 1 104 096 A2

**Beschreibung**

Die Erfindung betrifft ein Verfahren zur Reduktion von Geräuschsignalen bei Telekommunikations(=TK)-Systemen für die Übertragung von akustischen Nutzsignalen, insbesondere menschlicher Sprache, bei dem der Leistungswert des Geräuschpegels N im aktuell benutzten TK-Kanal fortlaufend gemessen und/oder geschätzt wird.

Ein solches Verfahren ist beispielsweise bekannt aus der DE 42 29 912 A1.

Während einer natürlichen Kommunikation zwischen Menschen passt man in der Regel die Amplitude der gesprochenen Sprache automatisch an die akustische Umgebung an. Bei einer Sprachkommunikation zwischen entfernten Orten jedoch befinden sich die Gesprächspartner nicht im selben akustischen Umfeld und sind sich daher jeweils nicht der akustischen Situation am Ort des anderen Gesprächspartners bewusst. Besonders verschärft tritt daher ein Problem auf, wenn einer der Partner aufgrund seiner akustischen Umgebung gezwungen ist, sehr laut zu sprechen, während der andere Partner in einer leisen akustischen Umgebung Sprachsignale mit geringer Amplitude erzeugt.

Hinzu kommt das Problem, dass auf einem TK-Kanal auch ein "elektronisch erzeugtes" Geräusch entsteht und als Hintergrund zum Nutzsignal mitübertragen wird. Um den Komfort beim Telefonieren zu erhöhen, ist man deshalb bestrebt, jede Art von Geräusch möglichst gering zu halten.

Schließlich ist es auch vorteilhaft, Störsignale wie unerwünschten Hintergrundlärm (Straßenlärm, Fabriklärm, Bürolärm, Kantinenlärm, Fluglärm etc.) zu reduzieren oder ganz zu unterdrücken.

Ein bekanntes Verfahren zur Geräuschreduktion ist die sogenannte "spektrale Subtraktion", die beispielsweise in der Veröffentlichung "A new approach to noise reduction based on auditory masking effects" von S. Gustafsson und P. Jax, ITG-Fachtagung, Dresden, 1998, beschrieben ist. Dabei handelt es sich um ein spektrales Geräuschabsenkungsverfahren, bei dem eine akustische Verdeckungsschwelle (beispielsweise nach dem MPEG-Standard) berücksichtigt wird. Nachteilig bei derartigen Verfahren ist die aufwendige Bestimmung dieser akustischen Verdeckungsschwelle und die Ausführung aller mit diesem Verfahren verbundenen Rechenoperationen.

Bei einer spektralen Subtraktion wird zunächst das Geräusch in den Sprachpausen gemessen und in Form eines Leistungsdichtespektrums fortlaufend in einem Speicher abgelegt. Das Leistungsdichtespektrum wird über eine Fourier Transformation gewonnen. Beim Auftreten von Sprache wird sodann das gespeicherte Geräuschspektrum "als bester aktueller Schätzwert" vom aktuellen gestörten Sprachspektrum subtrahiert, sodann in den Zeitbereich zurücktransformiert, um auf diese Weise eine Geräuschreduktion für das gestörte Signal zu erhalten.

Ein weiterer Nachteil der spektralen Subtraktion besteht darin, dass durch den Vorgang einer prinzipiell nicht genauen spektralen Geräuschschätzung und nachfolgender Subtraktion auch Fehler im Ausgangssignal auftreten, die sich als "musical tones" bemerkbar machen.

Bei der erweiterten spektralen Signalbearbeitung, die ebenfalls in dem genannten Zitat beschrieben ist, werden zunächst mit Hilfe einer spektralen Subtraktion die Leistungsdichtespektren für das Geräusch und für die Sprache selbst geschätzt. Aus der Kenntnis dieser Teilspektren wird sodann mit Hilfe z.B. der Regeln aus dem MPEG Standard eine spektrale akustische Verdeckungsschwelle $R_T(f)$ für das menschliche Ohr berechnet. Mit Hilfe dieser Verdeckungsschwelle und den geschätzten Spektren für Geräusch und Sprache wird sodann nach einer einfachen Regel eine Filterdurchlasskurve H(f) berechnet, die so gestaltet ist, dass wesentliche spektrale Teile der Sprache möglichst unverändert durchgelassen und spektrale Teile des Geräusches möglichst abgesenkt werden.

Sodann wird das originale gestörte Sprachsignal nur durch dieses Filter gegeben, um auf diese Weise eine Geräuschreduktion für das gestörte Signal zu erhalten. Der Vorteil dieses Verfahrens besteht nun darin, dass vom gestörten Signal "Nichts addiert oder subtrahiert" wird und daher Fehler in den Schätzungen weniger bis kaum wahrnehmbar sind. Nachteilig ist wieder der erheblich größere Rechenaufwand.

Bei dem bekannten Kompander-Verfahren, wie es beispielsweise in der eingangs zitierten DE 42 29 912 A1 beschrieben ist, wird der Grad der Geräuschabsenkung gemäß einer fest vorgegebenen Transferfunktion festgelegt.

Der Kompander hat zunächst die Eigenschaft, Sprachsignale mit einem bestimmten (vorab eingestellten) "normalen Sprachsignalpegel" (ggf. normale Lautstärke genannt) praktisch unverändert von seinem Eingang zum Ausgang zu übertragen.

Wird nun aber das Eingangssignal einmal zu laut, z.B. weil ein Sprecher zu dicht an sein Mikrofon kommt, so begrenzt ein Dynamik-Kompressor den Ausgangspegel auf nahezu den gleichen Wert wie im Normalfall, indem die aktuelle Verstärkung im Kompander mit zunehmender Eingangslautstärke linear abgesenkt wird. Durch diese Eigenschaft bleibt die Sprache am Ausgang des Kompandersystems etwa gleich laut - unabhängig davon wie stark die Eingangslautstärke schwankt.

Wird nun andererseits ein Signal mit einem Pegel, der kleiner als der Normalpegel ist, auf den Eingang des Kompanders gegeben, so wird das Signal zusätzlich gedämpft, indem die Verstärkung zurückgeregelt wird, um Hintergrundgeräusche möglichst nur abgeschwächt zu übertragen.

Der Kompander besteht somit aus zwei Teilfunktionen, einem Kompressor für Sprachsignalpegel, die größer oder gleich einem Normalpegel sind und einem Expander für Signalpegel, die kleiner als der Normalpegel sind.

Aufgabe der vorliegenden Erfindung ist es demgegenüber, ein Verfahren mit den eingangs beschriebenen Merkmalen vorzustellen, bei dem in möglichst unaufwendiger Art und Weise ein Grad der Geräuschabsenkung angepasst an die jeweilige Situation ermittelt und zur Steuerung einer Geräuschunterdrückung verwendet wird. Dabei sollte das Verfahren mit einfachen Mitteln ermöglichen, einen für das menschliche Ohr möglichst angenehmen akustischen Gesamteindruck zu erzeugen, der je nach Geschmack an individuelle Bedürfnisse angepasst werden kann.

Erfindungsgemäß wird diese Aufgabe auf ebenso einfache wie wirkungsvolle Art und Weise dadurch gelöst, dass in Abhängigkeit vom aktuellen Geräuschpegel N laufend der Grad der aktuell vorzunehmenden Reduktion des Geräuschpegels N nach einer vorgegebenen Funktion f(N) automatisch eingestellt wird.

Damit wird der Grad einer Geräuschabsenkung vom aktuell auftretenden Leistungswert N des Geräusches automatisch mitgesteuert und dem aktuellen Geräuschwert im Telefonkanal angepasst und in vorbestimmter definierter Weise nachgeführt. Über die Wahl der Funktion f(N) kann auch der subjektive Eindruck des erzeugten Gesamtsignals angepasst werden.

Ein weiterer Vorteil des erfindungsgemäßen Verfahrens besteht darin, dass bei einem Bündel von Telefonkanälen, beispielsweise zwischen internationalen Vermittlungsstellen, die Geräuschsituation in jedem einzelnen Kanal, die ja von Kanal zu Kanal sehr verschieden sein kann, automatisch eingestellt und individuell optimiert werden kann.

Besonders bevorzugt ist eine Variante des erfindungsgemäßen Verfahrens, die sich dadurch auszeichnet, dass die vorgegebene Funktion f(N) eine Funktion g(S/N) ist, die vom Quotienten S/N aus dem Leistungswert des Signalpegels S der zu übertragenden Nutzsignale und dem Leistungswert des Geräuschpegels N abhängt, oder dass die vorgegebene Funktion f(N) eine Funktion g'(N/S) ist, die vom Kehrwert N/S dieses Quotienten abhängt. Aus Gründen einer einfacheren praktischen Realisierung kann man auch eine Funktion von (S+N)/N oder von (S+N)/S verwenden.

Der Vorteil der obigen Verfahrensvariante besteht darin, dass bei stark variierendem Nutzsignalpegel S in den Telefonkanälen eines Bündels immer die richtige Einstellung für die Geräuschabsenkung gefunden wird. Bei einer Steuerung der Geräuschreduktion proportional zum Kehrwert N/S lässt sich die Funktion g'(N/S) leicht auf einem digitalen Signalprozessor (=DSP) mit festen Computerwortlängen von beispielsweise 16 bit unter Verwendung von besonders einfacher Software implementieren, da für N/S vorzugsweise ein Zahlenbereich $0 < N/S < 1$ zur Steuerung der Geräuschreduktion relevant bzw. interessant ist.

Akustische Gehörtests haben ergeben, dass bei S/N = 0 db die Sprache bereits so stark gestört ist, dass man das Geräusch nur bedingt um einen Wert $f_0$ bzw. $g_0$ zwischen 5 und 10 dB, vorzugsweise zwischen 6 und 8 dB reduzieren darf, um den akustischen Gesamteindruck im Hinblick auf eine Natürlichkeit der Sprache nicht zu verschlechtern. Bei noch ungünstigeren Werten des Signal-zu-Rausch-Verhältnisses S/N < 0 dB kann dann der Wert $f_0$ bzw. $g_0$ beibehalten werden, da jede weitere Geräuschabsenkung den Gesamteindruck nur verschlechtert.

Bei mittleren S/N kann gemäß diesen Untersuchungen eine stärkere Geräuschabsenkung vorgenommen werden. Ein Maximum ergibt sich dabei im Bereich 10 bis 15 dB. Der Wert der Geräuschabsenkung $f_{max}$ bzw. $g_{max}$ sollte im Maximum zwischen 20 und 30, vorzugsweise etwa 25 dB betragen.

Bei sehr guten Rauschwerten S/N > 40 dB sollte nur noch eine minimale Absenkung zwischen 0 und 3 dB eingestellt werden, um die Natürlichkeit der übertragenen Sprache so gut wie möglich zu erhalten.

Der Klang der Sprache und die Verständlichkeit sind besonders gut, wenn die Funktion f(N) bzw. g(S/N) über die drei oben diskutierten Bereiche hinweg in stetiger Weise miteinander zusammenhängt, wobei schnelle Änderungen in N oder in S(N) vorteilhaft durch Filterungen geglättet werden können.

Eine relativ einfache Realisierung in Hardware und/oder Software ergibt sich, indem man die Funktionen f(N) bzw. g(S/N) bzw. g'(N/S) durch gerade Kennlinienstücke zwischen den drei oben beschriebenen Betriebspunkten approximiert (abschnittsweise lineare Näherung).

Bei einer etwas aufwendigeren Variante des erfindungsgemäßen Verfahrens, die aber im Ergebnis zu einem besseren Klangbild führt, wird eine Polynomfunktion zur Implementierung der stetigen Funktionen f(N) bzw. g(S/N) bzw. g'(N/S) in den drei diskutierten Bereichen herangezogen, was im Ergebnis zu einer Art unsymmetrischer Glokkenfunktion führt.

Besonders bevorzugt ist eine Variante des erfindungsgemäßen Verfahrens, bei der die Funktionen f(N) bzw. g(S/N) oder g'(N/S) so gewählt werden, dass die Reduktion des Geräuschpegels N gehörrichtig gemäß den psychoakustischen Mittelwerten des menschlichen Gehörspektrums erfolgt. Dabei wird der Wert für S und/oder N nicht nur aus dem momentanen Leistungswert alleine, sondern auch aus einem gewichteten spektralen Verlauf von S bzw. N bestimmt und insgesamt über die so gewonnene Funktion eine gehörrichtige, d.h. eine psychoakustisch angenehm klingende Geräuschreduktion erzielt. Da es kein einfach darstellbares Maß für eine akustisch angenehm klingende Geräuschreduktion gibt, sind alle Qualitätsbeurteilungen auf umfangreiche Gehörtests angewiesen, die anschließend mittels dafür optimierter statistischer Methoden ausgewertet werden, um einen Bewertungsmaßstab, (ähnlich wie bei Sprachcodecs) zu erhalten.

Eine gute Geräuschpegel-Schätzung erfordert einen guten Sprach-Pausen-Detektor, da man nur dann sicher sein kann, dass in den Sprachpausen-Abschnitten lediglich störendes Geräusch und nicht irgendeine Mischung zwischen Geräusch und Sprachfetzen vorliegt, wie es in der Praxis häufig vorkommt.

Um eine effektive Geräuschreduktion zu erzielen, wird vorzugsweise das zu übertragende Signal während der Sprachpausen in seinem Leistungswert gemäß einer Exponentialfunktion abgesenkt. Damit wird bereits eine wesentliche Geräuschminderung erzielt. Während der Sprachabschnitte werden Geräusche zumindest teilweise durch die Sprache selbst maskiert und daher insgesamt weniger wahrgenommen. Hinzu kommt, dass eine Absenkung der Geräusche während einer Sprachpause das Gehör deutlich weniger belastet, indem es den Taubheitseffekt nach lauter Schalleinwirkung wesentlich mindert. Das Ohr kann bei Wiedereinsetzen der Sprache empfindlicher reagieren und genauer hinhören.

Besonders bevorzugt ist auch eine Verfahrensvariante, die sich dadurch auszeichnet, dass im Sprach-Pausen-Detektor aus dem Eingangssignal x mittels eines Kurzzeit-Pegelschätzers ein Kurzzeit-Ausgangssignal sam(x), mittels eines Mittelzeit-Pegelschätzers ein Mittelzeit-Ausgangssignal mam(x) und mittels eines Langzeit-Pegelschätzers ein Langzeit-Ausgangssignal lam(x) gebildet wird, dass die drei Ausgangssignale sam(x), mam(x) und lam(x) über geeignete Verstärkungskoeffizienten so eingestellt werden, dass sie etwa gleich groß, wenn das Eingangssignal x ein reines Rauschsignal ist, wobei sam(x) < mam(x) < lam(x), dass die drei Ausgangssignale sam(x), mam(x) und lam(x) von Komparatoren überwacht werden, und dass das Vorliegen eines Sprachsignals als Eingangssignal x angenommen wird, wenn sam(x) und mam(x) zunächst jeweils größer werden als lam(x), und das Vorliegen einer Sprachpause, wenn danach sam(x) und/oder mam(x) wieder kleiner wird als lam(x).

Mit Hilfe dieser relativ einfachen Arten der Bildung von verschiedenen Mittelwerten des Zeitsignals kann bereits eine überraschend gute Sprachpausen-Detektion durchgeführt werden, die nur einen sehr geringen Rechenaufwand erfordert.

Eine Weiterbildung dieser Verfahrensvariante sieht vor, dass die drei Ausgangssignale sam(x), mam(x) und lam(x) zur Sprach-Pausen-Abschätzung einem neuronalen Netz zugeführt werden, das mit einer Vielzahl von Szenarien mit unterschiedlichen Eingangssignalen x trainiert wurde. Ein neuronales Netz kann vorteilhaft lineare und nichtlineare Zusammenhänge zwischen einer großen Menge von Eingabeparametern und den gewünschten Ausgabewerten abbilden. Eine Voraussetzung dafür ist, dass das neuronale Netz einmal mit einer hinreichenden Menge von Eingabewerten und zugehörigen Ausgabewerten trainiert wurde. Daher eignen sich neuronale Netze besonders für die Aufgabe einer Sprachpausen-Detektion bei Anwesenheit von unterschiedlichen störenden Geräuschen.

Vorzugsweise wird zusätzlich zur Erkennung und Reduktion von Geräuschsignalen auch das Vorliegen von Echosignalen detektiert und/oder vorhergesagt und die entsprechenden Echosignale unterdrückt oder reduziert. Wenn in einem Telefonkanal zusätzlich zu Geräuschen auch Echos auftreten, so können diese in der Regel anhand einer vorab ermittelten Signallaufzeit $\tau_E$ eines Echos sowie der vorab ermittelten Echokopplung ERL im Kanal und der Signalstärke ES, die das Echo im Rückkanal auslöst, vorhergesagt werden. Man kann diese Schätzung in der Weise durchführen, dass in Abhängigkeit vom ausgesendeten Sprachsignal und seiner momentanen Leistung die Größe der verzögert eintreffenden Echos abgeschätzt wird. Überschreitet das jeweils geschätzte Echosignal in bestimmten kurzen Zeitabschnitten einen vorgegebenen Schwellwert thrs, so wird dieses echobehaftete Signal vorzugsweise kurzzeitig zusätzlich, beispielsweise durch die oben erwähnte exponentielle Absenkung, auf einen Wert gedämpft, der für eine wesentliche Reduktion des Echosignals erforderlich ist. Im gleichen Sinn kann auch eine Kompander-Kennlinie kurzzeitig bei Echos in die Richtung größerer Eingangslautstärke verschoben und nach Abklingen der Echos wieder in ihre ursprüngliche Lage zurückgeführt werden.

So kann man vorteilhaft eine gehörrichtige Geräuschabsenkung mit einer unabhängig davon arbeitenden Echoreduktion verbinden. Das ist besonders dann wichtig, wenn im Telefonkanal so gut wie kein Hintergrundgeräusch existiert, da dann keine Geräuschabsenkung wirksam wird, und somit auftretende Echos ungehindert zum Sprecher gelangen können.

Eine Trennung der Steuerung einer Geräuschreduktion von der einer Echoabsenkung ist zweckmäßig, da Geräusche und Echos unabhängig voneinander auftreten und auch in der Regel völlig unterschiedliche physikalische Ursachen haben. Man kann aber mathematisch eine generelle Reduktionsfunktion R angeben, die eine Absenkung von Signalpegeln sowohl für Geräusche als auch für Echos beschreibt:

$$R(S, N, ES, \tau_E, ERL, thrs) \sim g(S/N) \, d(ES, \tau_E, ERL, thrs) \, ,$$

wobei g(S/N) die oben beschriebene Geräuschreduktion und d(...) die unabhängig zusätzlich einsetzende Echoabsenkung bedeuten, wenn das geschätzte Echosignal den vorgegebenen Schwellwert thrs überschreitet.

Besonders vorteilhaft ist eine Verfahrensvariante, bei der während der Zeitdauer einer Echo-Reduktion zum Nutzsignal zusätzlich ein künstliches Geräuschsignal addiert wird.

Eine Geräuschabsenkung ist bei gleichbleibendem Geräuschpegel ebenfalls konstant. Eine plötzlich zusätzlich einsetzende Echoreduktion im Rhythmus der Sprache bedeutet auch eine Geräuschabsenkung (zumindest in dem kurzen Zeitabschnitt) im Sprachrhythmus. Dies führt zu einem gepulsten Hintergrundgeräusch, welches sich nicht natürlich anhört. Daher ist es vorteilhaft, in den Augenblicken einer zusätzlichen Echoreduktion ein synthetisches Geräusch eines geeigneten Rauschgenerators in der Größenordnung des normalen Hintergrundgeräusches zum bearbeiteten Signal hinzuzufügen. Damit soll ein möglichst gleichbleibendes Hintergrundgeräusch für den Hörer vermittelt werden.

Der Rauschgenerator kann so gestaltet werden, dass das künstliche Geräuschsignal eine psychoakustisch als angenehm empfundene akustische Signalsequenz (=comfort noise) umfasst.

Anstelle eines synthetischen Hintergrundgeräusches kann aber auch ein Abschnitt eines zuvor aufgezeichneten echten Hintergrundgeräusches in passender Stärke in den Echozeitabschnitten eingefügt werden. Das hinzugefügte Geräusch unterscheidet sich dann so gut wie überhaupt nicht vom vorherigen Geräusch und wird daher keine störende akustische Veränderung beim Hörer hervorrufen.

Das Hinzufügen von Geräuschen zur akustischen Verdeckung von Effekten sowie die Maßnahmen einer getrennten Behandlung von Geräuschen und Echos werden, wenn sie richtig aufeinander abgestimmt sind, einen besonders verständlichen und angenehmen Spracheindruck auch bei "schwieriger" Umgebung (Echos plus Geräusche) bewirken.

In den Rahmen der vorliegenden Erfindung fällt auch eine Servereinheit zur Unterstützung des oben beschriebenen erfindungsgemäßen Verfahrens sowie ein Computerprogramm zur Durchführung des Verfahrens. Das Verfahren kann sowohl als Hardwareschaltung, als auch in Form eines Computerprogramms realisiert werden. Heutzutage wird eine Software-Programmierung für leistungsstarke DSP's bevorzugt, da neue Erkenntnisse und Zusatzfunktionen leichter durch eine Veränderung der Software auf bestehender Hardwarebasis implementierbar sind. Verfahren können aber auch als Hardwarebausteine beispielsweise in TK-Endgeräten oder Telefonanlagen implementiert werden.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1a    die Funktion g(S/N) in der linearen Näherung;

Fig. 1b    die entsprechende Funktion g'(N/S);

Fig. 2a    die Funktion g(S/N) als unsymmetrische Glockenkurve;

Fig. 2b    die entsprechende Funktion g'(N/S); und.

Fig. 3    ein Schema einer Anordnung zur gesteuerten Signalabsenkung.

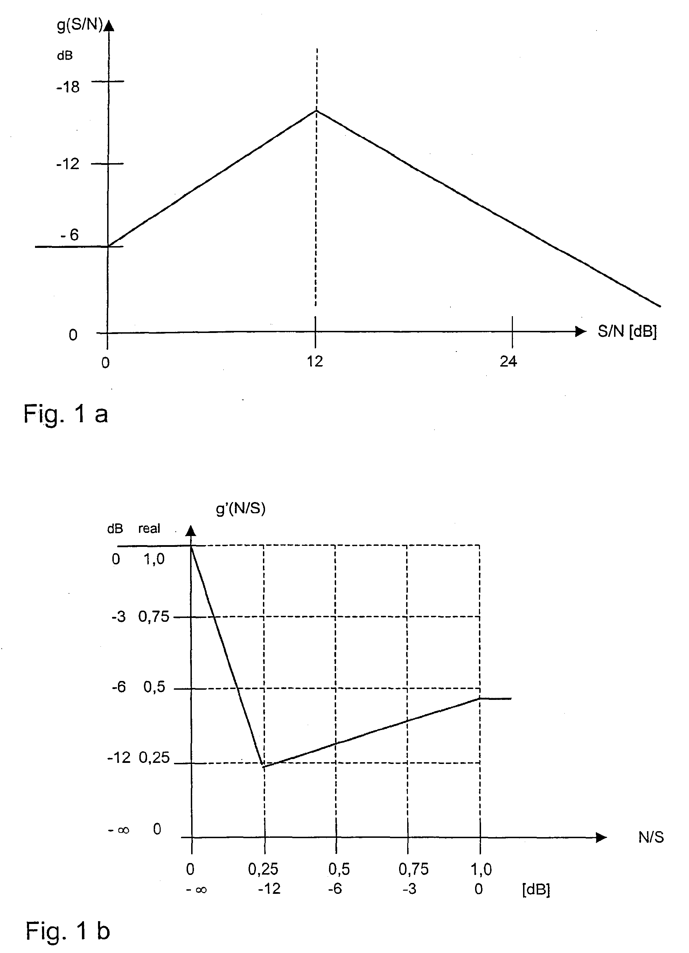

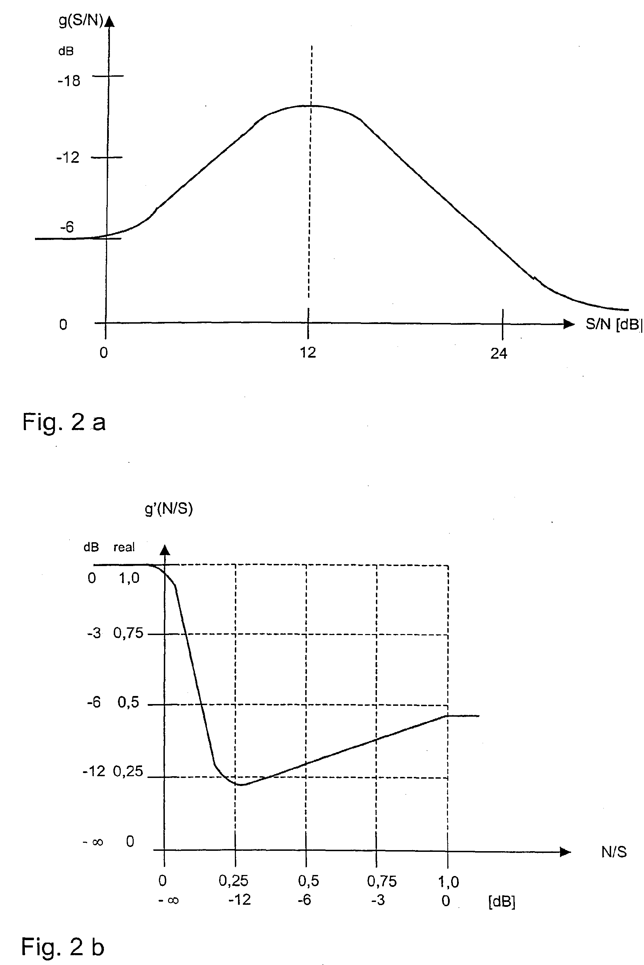

Für sämtliche in den Figuren 1a bis 2b dargestellten Kurven gilt, dass der Funktionswert g bzw. g' für den Fall S/N < 0, also bei extrem hohem Geräuschhintergrund, in einen konstanten Wert go der Geräuschreduktion von etwa 6 dB übergeht. Beginnend von S/N = 0 wird mit zunehmender Verbesserung des Signal-zu-Rausch-Verhältnisses S/N eine erhöhte Geräuschreduktion vorgenommen, die ein Maximum $g_{max} \approx 25$ dB bei etwa $S/N \approx 12$dB erreicht. Mit weiter zunehmendem S/N sinkt der Grad der Geräuschreduktion schließlich gegen Null, um bei geringem Hintergrundgeräusch möglichst wenig Manipulationen im übertragenen Nutzsignal vorzunehmen.

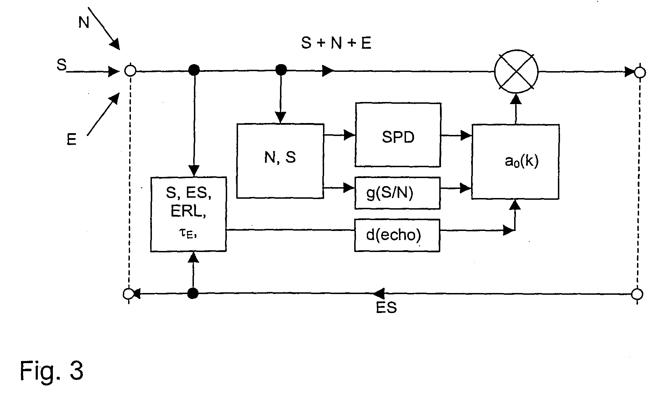

In Fig.3 schließlich ist schematisch die Funktionsweise einer Anordnung zur Geräusch- und Echoreduktion entsprechend der oben genannten Reduktionsfunktion R(S, N, ES, $\tau_E$, ERL, thrs) mit einem Sprach-Pausen-Detektor SPD dargestellt.

**Patentansprüche**

1.  Verfahren zur Reduktion von Geräuschsignalen bei Telekommunikations(=TK)-Systemen für die Übertragung von akustischen Nutzsignalen, insbesondere menschlicher Sprache, bei dem der Leistungswert des Geräuschpegels N im aktuell benutzten TK-Kanal fortlaufend gemessen und/oder geschätzt wird,
    dadurch gekennzeichnet,
    dass in Abhängigkeit vom aktuellen Geräuschpegel N laufend der Grad der aktuell vorzunehmenden Reduktion des Geräuschpegels N nach einer vorgegebenen Funktion f(N) automatisch eingestellt wird.

2. Verfahren nach Anspruch 1, dadurch gekennzeichnet, dass die vorgegebene Funktion f(N) eine Funktion g(S/N) ist, die vom Quotienten S/N aus dem Leistungswert des Signalpegels S der zu übertragenden Nutzsignale und dem Leistungswert des Geräuschpegels N abhängt, oder dass die vorgegebene Funktion f(N) eine Funktion g'(N/S) ist, die vom Kehrwert N/S dieses Quotienten abhängt.

3. Verfahren nach Anspruch 1 oder 2, dadurch gekennzeichnet, dass die Funktion f(N) bzw. g(S/N) bei 1/N << 1 bzw. S/N = 0 dB mit einem konstanten Wert $f_0 > 0$ bzw. $g_0 > 0$ beginnt, im Bereich zwischen N bzw. S/N = 10 dB bis 15 dB, vorzugsweise bei N bzw. S/N $\approx$ 12 dB, auf ein Maximum $f_{max}$ bzw. $g_{max}$ ansteigt und anschließend auf einen Minimalwert $f_{min}$ bzw. $g_{min}$, vorzugsweise auf 0 dB abfällt.

4. Verfahren nach Anspruch 3, dadurch gekennzeichnet, dass 5 dB $\leq f_0, g_0 \leq$ 10dB, vorzugsweise 6dB $\leq f_0, g_0 \leq$ 8dB.

5. Verfahren nach Anspruch 3 oder 4, dadurch gekennzeichnet, dass 20 dB $\leq f_{max}, g_{max} \leq$ 30 dB, vorzugsweise $f_{max}$, $g_{max} \approx$ 25 dB.

6. Verfahren nach einem der Ansprüche 3 bis 5, dadurch gekennzeichnet, dass die Funktion f(N) bzw. g(S/N) zumindest stückweise, vorzugsweise in allen Teilabschnitten linear mit N bzw. S/N verläuft.

7. Verfahren nach einem der Ansprüche 3 bis 5, dadurch gekennzeichnet, dass die Funktion f(N) bzw. g(S/N) aus Polynomen aufgebaut ist und als unsymmetrische Glockenkurve über N bzw. S/N verläuft.

8. Verfahren nach einem der vorhergehenden Ansprüche, dadurch gekennzeichnet, dass die Funktionen f(N) bzw. g(S/N) oder g'(N/S) so gewählt werden, dass die Reduktion des Geräuschpegels N gehörrichtig gemäß den psychoakustischen Mittelwerten des menschlichen Gehörspektrums erfolgt.

9. Verfahren nach einem der vorhergehenden Ansprüche, dadurch gekennzeichnet, dass zur Erkennung des Geräuschpegels N ein Sprach-Pausen-Detektor (SPD) eingesetzt wird.

10. Verfahren nach Anspruch 9, dadurch gekennzeichnet, dass das zu übertragende Signal während der Sprachpausen in seinem Leistungswert gemäß einer Exponentialfunktion abgesenkt wird.

11. Verfahren nach Anspruch 9 oder 10, dadurch gekennzeichnet,

dass im Sprach-Pausen-Detektor (SPD) aus dem Eingangssignal x mittels eines Kurzzeit-Pegelschätzers ein Kurzzeit-Ausgangssignal sam(x), mittels eines Mittelzeit-Pegelschätzers ein Mittelzeit-Ausgangssignal mam(x) und mittels eines Langzeit-Pegelschätzers ein Langzeit-Ausgangssignal lam(x) gebildet wird,
dass die drei Ausgangssignale sam(x), mam(x) und lam(x) über geeignete Verstärkungskoeffizienten so eingestellt werden, dass sie etwa gleich groß, wenn das Eingangssignal x ein reines Rauschsignal ist, wobei sam(x) < mam(x) < lam(x),
dass die drei Ausgangssignale sam(x), mam(x) und lam(x) von Komparatoren überwacht werden,
und dass das Vorliegen eines Sprachsignals als Eingangssignal x angenommen wird, wenn sam(x) und mam(x) zunächst jeweils größer werden als lam(x), und das Vorliegen einer Sprachpause, wenn danach sam(x) und/oder mam(x) wieder kleiner wird als lam(x).

12. Verfahren nach Anspruch 11, dadurch gekennzeichnet, dass die drei Ausgangssignale sam(x), mam(x) und lam(x) zur Sprach-Pausen-Abschätzung einem neuronalen Netz zugeführt werden, das mit einer Vielzahl von Szenarien mit unterschiedlichen Eingangssignalen x trainiert wurde.

13. Verfahren nach einem der vorhergehenden Ansprüche, dadurch gekennzeichnet, dass zusätzlich zur Erkennung und Reduktion von Geräuschsignalen das Vorliegen von Echosignalen detektiert und/oder vorhergesagt wird und die Echosignale unterdrückt oder reduziert werden.

14. Verfahren nach Anspruch 13, dadurch gekennzeichnet, dass die Steuerung der Reduktion von Geräuschsignalen und der Reduktion von Echosignalen getrennt erfolgt.

15. Verfahren nach Anspruch 13 oder 14, dadurch gekennzeichnet, dass während der Zeitdauer einer Echo-Reduktion zum Nutzsignal zusätzlich ein künstliches Geräuschsignal addiert wird.

**16.** Verfahren nach Anspruch 15, dadurch gekennzeichnet, dass das künstliche Geräuschsignal eine psychoakustisch als angenehm empfundene akustische Signalsequenz (=comfort noise) umfasst.

**17.** Verfahren nach Anspruch 15, dadurch gekennzeichnet, dass das künstliche Geräuschsignal ein zuvor während der aktuellen TK-Verbindung aufgezeichnetes Geräuschsignal umfasst.

**18.** Servereinheit zur Unterstützung des Verfahrens nach einem der Ansprüche 1 bis 17.

**19.** Computerprogramm zur Durchführung des Verfahrens nach einem der Ansprüche 1 bis 17.

Fig. 1 a

Fig. 1 b

Fig. 2 a

Fig. 2 b

Fig. 3